**Europäisches Patentamt**

**European Patent Office**

**Office européen des brevets**

(19)

(11) Publication number: **0 177 194**
**A2**

# (12) EUROPEAN PATENT APPLICATION

(21) Application number: **85306325.3**

(22) Date of filing: **05.09.85**

(51) Int. Cl.⁴: **C 30 B 15/10**
**C 30 B 15/14**

(30) Priority: **05.09.84 JP 185597/84**
**05.09.84 JP 185598/84**

(43) Date of publication of application:
**09.04.86 Bulletin 86/15**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

(72) Inventor: **Komeya, Katsutoshi**
**c/o Patent Div. 1-1 Shibaura 1-chome**
**Minato-ku, Tokyo 105(JP)**

(72) Inventor: **Tsuge, Akihiko**
**c/o Patent Div. 1-1 Shibaura 1-chome**
**Minato-ku, Tokyo 105(JP)**

(72) Inventor: **Nakanishi, Masae**
**c/o Patent Div. 1-1 Shibaura 1-chome**
**Minato-ku, Tokyo 105(JP)**

(72) Inventor: **Watanabe, Masayuki**
**c/o Patent Div. 1-1 Shibaura 1-chome**
**Minato-ku, Tokyo 105(JP)**

(72) Inventor: **Washizuka, Shiyouichi**
**c/o Patent Div. 1-1 Shibaura 1-chome**
**Minato-ku, Tokyo 105(JP)**

(72) Inventor: **Yaskiro, Sadao**
**c/o Patent Div. 1-1 Shibaura 1-chome**
**Minato-ku, Tokyo 105(JP)**

(74) Representative: **Freed, Arthur Woolf et al,**
**MARKS & CLERK 57-60 Lincoln's Inn Fields**
**London WC2A 3LS(GB)**

(54) Apparatus for production of compound semiconductor single crystal.

(57) An apparatus for the production of a compound semiconductor single crystal comprises a high-pressure container (1), a crucible (2) and a crucible stand (3) disposed inside the high-pressure container (1), a heat generator (4) encircling the crucible and the crucible stand, a heat-insulating member (5) disposed outside the heat generator, and a crystal pulling device (6) disposed above the crucible (2) in such a manner as to be freely moved in a vertical direction. The crucible stand (3) and/or heat-insulating member (5) is formed of sintered pieces of poly-type aluminium nitride containing as a sintering aid at least one member selected from the oxides of the Group IIIa and IIa elements or sintered pieces of a aluminum nitride coated with said poly-type aluminium nitride.

This apparatus permits production of a single crystal of larger size and higher quality than the conventional counter-type, because the crucible stand (3) and the heat-insulating member (5) yield to much less deterioration due to oxidation and exhibit higher heat-insulating ability and the melt of raw material for crystal is minimally contaminated by the product of oxidation.

## APPARATUS FOR PRODUCTION OF
## COMPOUND SEMICONDUCTOR SINGLE CRYSTAL

This invention relates to an apparatus to be used in the production of a compound semiconductor single crystal by the LEC method.

Heretofore, as means of producing such compound semiconductor singlecrystals as GaAs, Gap and InP which exhibit high levels of decomposition pressure at their melting points, the LEC method has been known to the art.

This method necessitates use of an apparatus which comprises a crucible for melting a raw material for crystal and a sealing agent such as $B_2O_3$, a heat generator for heating the crucible, a crystal pulling device for pulling a crystal from within the crucible, and a high-pressure container covering all the components mentioned above.

In accordance with the LEC method, the compound semiconductor crystal is produced in the apparatus described above by the following procedure.

First, the heat generator melts the raw material for crystal and the sealing agent as held inside the crucible by application of heat.

Since the melt of the raw material for crystal has a greater density than the melt of the sealing agent and, therefore, has its surface coated with the melt of the sealing agent, otherwise possible vaporization of this melt due to decomposition is repressed. Further, since the interior of the high-pressure container is pressed with inert gas, otherwise possible gasification of the melt of the raw material for crystal is curbed.

Then, a seed crystal is attached fast to the leading end of the crystal pulling shaft. This seed crystal is passed through the melt of the sealing agent and brought into contact with the melt of the raw material for crystal. The single crystal aimed at is obtained by rotating the crystal pulling shaft around its axis and slowly lifting it.

The LEC method has the advantage that it produces the single crystal with a relatively simple apparatus. This method nevertheless suffers from the disadvantage that since the growth of crystal is carried out at elevated temperatures under high pressure, the temperature distribution within the crucible becomes uneven as because of convective radiation of heat from the atmosphere and the melt and, consequently, the single crystal tends to sustain fault.

For the purpose of uniformizing the temperature

3   0177194

distribution within the crucible and, at the same time, enhancing the thermal efficiency of the heat generator, the practice of disposing heat-insulating members on the vertical sides and the horizontal sides of the heat generator so as to shield the heat generator against flow of heat is prevailing.  The practice of keeping the crucible on such a heat-insulating member is also popular.  As the heat-insulating members for enclosing the heat generator and the heat-insulating member used for isolating the crucible from the supporting base, those made of carbon material have been used because they are easy to fabricate and they have light weight.

These carbon products have poor durability because they are readily deteriorated through oxidation by the ambient air, the oxygen or steam entrained in small amounts in $B_2O_3$, or the oxygen or steam adsorbed and contained in the carbon products themselves.  They, therefore, have the disadvantage that the product of this oxidation finds its way into the crucible and defiles the raw material for crystal under treatment therein as it is carried on the convective flow of high-pressure gas.

Formerly, the inventors found sintered pieces of aluminum nitride are suitable for such a crucible stand and heat-insulating members as described above and proposed use of the sintered pieces of aluminum nitride as materials for the crucible stand and the heat-insulating members.

The crucible stand and the heat-insulating members made of the sintered pieces of aluminum nitride are minimally

4

deteriorated through oxidation and, as a result, otherwise possible contamination of the melt of raw material for crystal by the product of oxidation is decreased and the quality of the produced crystal improved.

There is a growing demand for further increase in the size of the single crystal to be produced. In this connection, the desirability of developing new crucible stand and heat-insulating members which yield far less to the deterioration through oxidation and suffer far less from contamination of the melt of raw material for crystal by the product of oxidation than the crucible stand and the heat-insulating members made of such aluminum nitride has been finding growing recognition.

An object of this invention, therefore, is to provide an apparatus for the production of a compound semiconductor single crystal, capable of producing a single crystal of larger size and higher quality by the use of a crucible stand and heat-insulating members of enhanced heat-insulating ability which yield minimally to deterioration through oxidation and suffer only nominal contamination of the melt of raw material for crystal by the product of oxidation.

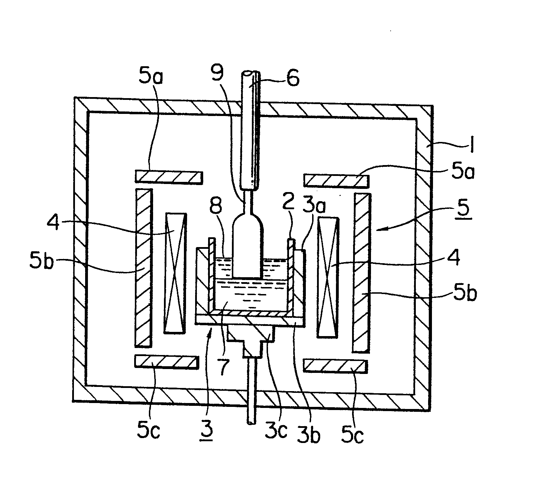

The drawing is a schematic cross-sectional diagram illustrating a typical apparatus as one embodiment of this invention.

An appratus of this invention for the production of a compound semiconductor single crystal essentially comprises, as illustrated in the drawing, a high-pressure container 1, a crucible 2 and a crucible stand 3 disposed inside the container 1, a heat generator 4 enclosing the crucible 2 and the crucible stand 3, a heat-insulating member 5 disposed outside the heat generator 4, and a crystal pulling device 6 disposed above the aforementioned crucible 2 in such a manner as to be freely moved in a vertical direction.

The crucible stand 3 is formed of a tubular part 3a, a bottom plate part 3b, and a supporting part 3c.

The heat-insulating member 5 is formed of an annular lid part 5a, a tubular part 5b, and an annular bottom plate part 5c. These components are severally produced either integrally or aggregates of a plurality of pieces.

For the purpose of the present invention, the crucible stand 3 and the heat-insulating member 5 are made of a material consisting of sintered pieces of poly-type aluminum nitride  containing a sintering aid consisting of the oxide of the Group IIIa and/or IIa elements or sintered pieces of aluminum nitride coated with the above poly-type aluminum nitride.

The crucible stand 3 and/or the heat-insulating member 5 made of poly-type aluminum nitride as contemplated by this invention are produced by the following procedure, for example.

First, aluminum nitride is mixed with 0.1 to 10% by weight of silicon dioxide and a sintering aid, namely at least one member selected from the oxides of the IIIa elements, e.g., an oxide of rare earth element such as yttrium and those of the IIa elements, e.g., an oxide of Ba,

6          **0177194**

Ca or Sr. The resultant mixture is blended with a binder. The mixture molded in a prescribed shape such as a tube or sheet, then degreased, and heated in an atmosphere of inert gas such as nitrogen at elevated temperatures of 1,700 to 2,000 °C. When the molded mixture is sintered completely, there is obtained a heat-insulating member formed solely of an Al-Si-O-N type compound.

The crucible stand 3 and/or the heat-insulating member 5 made of aluminum nitride and coated with poly-type aluminum nitride is produced by the following procedure.

On the surface of an unsintered or sintered piece of aluminum nitride molded in a shape the heat-insulating member is prescribed to acquire, a silicon dioxide coating is formed by the CVD method or the spattering method. The coated piece is heated in an atmosphere of nitrogen, when not yet sintered, at a temperature exceeding 1,700°C to effect sintering of the molded piece and, when already sintered, at a temperature exceeding 1,500°C to effect reaction of the molded piece, to give rise to a heat-insulating member formed of sintered aluminum nitride piece coated with a poly-type aluminum nitride of an Al-Si-O-N type compound. In this case, the thickness of the poly-type aluminum nitride layer to be formed by the procedure described above depends on the thickness of the silicon dioxide layer.

Optionally, the poly-type aluminum nitride may have an Al-O-N type compound and it can be used in virtually the same way as that of the Al-Si-O-N type compound described above. The Al-O-N type compound can be prepared using at least one member of the oxides of the IIIa elements and those of the IIa elements.

In the present invention, the tubular heat-insulating member formed of a sintered piece of aluminum nitride having the external surface coated with the poly-type aluminum nitride warrants production of a semiconductor single crystal of excellent quality because it suffers from virtually no contamination of the melt of raw material for crystal and excels in the heat-insulating property.

The crucible stand 3 and/or the heat-insulating member 5 made of a sintered piece of a mixture of aluminum nitride with the oxide of a rare earth element and boron nitride is produced by the following procedure.

A mixture of the components mentioned above is blended with a binder such as paraffin. The resultant mixture is molded in a prescribed shape such as a tube or plate. The molded mixture is degreased and then, in an atmosphere of inert gas, sintered under atmospheric pressure or hot pressed at a temperature in the range of 1,700 to 2000°C, preferably in the range of 1,750 to 1950°C.

The amount of the sintering aid to be added suitably for the purpose just described falls below the level of 10% by weight, preferably in the range of 1 to 5% by weight, based on the total amount of the mixture of aluminum nitride, and the sintering aid. For enhancing the impact resistance of the sintered piece, boron may be added suitably in an amount below 30% by weight, preferably in the range of 10 to 20% by weight. The boron nitride to be used herein may be in a powdered form or in the form of fibers.

Now, the procedure used in the production of single crystal by the use of the apparatus described above will be explained below.

First, the crucible 2 containing the raw material for crystal and the sealing agent such as $B_2O_3$ is mounted in place on the crucible stand 3 and the heat generator 4 is energized to heat and melt the raw material for crystal and the sealing agent held inside the crucible 2.

Consequently, the melt 7 of raw material for crystal and the melt 8 of the sealing agent form two separate layers because of their difference in density. Since the melt 7 of raw material for crystal which has a higher density (about 5.7 $g/cm^3$ in the case of GaAs, about 5.0 $g/cm^3$ in the case of InP, or about 4.4 $g/cm^3$ in the case of GaP) is coated with the melt 8 of the sealing agent which has a lower density (about 1.5 $g/cm^3$ in the case of $B_2O_3$), otherwise possible decomposition and vaporization of the melt 7 of raw material for crystal are curbed. Further since the interior of the high-pressure container 1 is kept in a state pressed with an inert gas, otherwise possible gasification of the melt 7 of raw material for crystal is repressed.

In the state consequently assumed, a seed crystal 9 attached fast to the leading end of the crystal pulling shaft 6 is passed through the melt 8 of the sealing agent and brought into contact with the melt 7 of raw material for crystal. Thereafter, a single crystal 10 is obtained by rotating and lifting the pulling shaft 6.

Now, the present invention will be described below with reference to working examples.

Example 1:

A crucible stand 3 and a heat-insulating member 5 illustrated in the drawing were produced as follows.

A mixture consisting of 93% by weight of aluminum nitride having a particle diameter of 1.2 μm, 3% by weight of yttrium oxide having a particle diameter of 0.7 μm, and 4% by weight of silicon dioxide having a particle diameter of 0.2 μm was blended with a prescribed amount of paraffin. The resultant mix was molded, then degreased, and fired for necessary reaction in an atmosphere of nitrogen at about 2,000 °C for two hours. Consequently there were obtained a crucible stand and a heat-insulating member of poly-type aluminum nitride formed solely of an Al-Si-O-N type compound. These products excelled in heat insulating property, exhibiting a heat conduction coefficient about 1/10 of the heat conduction coefficient of the products of aluminum nitride.

In an appratus using these products, a GaAs single crystal was pulled by the procedure described above. Since the temperature distribution within the crucible was uniform, the fault of the produced crystal was notably smaller than when the apparatus used a crucible stand and a heat-insulating member both formed of aluminum nitride. The fault of the produced crystal was even less than 1/10 of the fault experienced when the apparatus used a crucible stand and a heat-insulating member formed of carbon.

Example 2:

A crucible stand 3 and a heat-insulating member 5 illustrated in the drawing were produced as follows.

The crucible stand 3 and the heat-insulating member 5 were produced by preparing unsintered pieces of aluminum nitride molded in prescribed shaped by the conventional method, forming a film silicon·dioxide 1μ m in thickness by the CVD method on the surface of such molded pieces, and thereafter firing the coated pieces for necessary reaction in an atmosphere of nitrogen at 2000℃ for two hours to form a layer of poly-type aluminum nitride on the surface.

In an apparatus using these products, a GaAs single crystal was pulled by the procedure described above. The fault of the produced single crystal was smaller than when the apparatus used a crucible stand and a heat-insulating member both formed of aluminum nitride.

Example 3:

A crucible stand 3 and a heat-insulating member 5 illustrated in the drawing were produced by the following procedure.

A mixture consisting of 79% by weight of aluminum nitride having a particle diameter of 1.2 μ m, 6% by weight of aluminum oxide, 3% by weight of yttrium oxide having a particle diameter of 0.7 μ m, and 12% by weight of boron nitride having a particle diameter of 0.5 μ m was blended with 7% by weight of paraffin. The resultant mix was molded in prescribed shapes, then degreased by heating at about 600
C for two hours, and subsequently sintered in an atmosphere
of nitrogen at about 1,850 °C for two hours under atmospheric
pressure. The sintered pieces consequently obtained were
found to have density of not less than 98% and a $\Delta Tc$ (value
of resistance to thermal shock) of 350 °C.

In an apparatus using the crucible stand 3 and the
heat-insulating member 5 made of aluminum nitride as
described above, a single crystal of GaAs was pulled by the
aforementioned method. It was consequently confirmed that
the heat generator exhibited sufficient heating efficiency
and the temperature distribution within the crucible was
amply proper, so that the apparatus could withstand more
than 10 repetitions of stable pulling of single crystal.
Even after 10 cycles of use, the crucible stand and the
heat-insulating member showed no noticeable deterioration.

In contrast, when a single crystal of GaAs was pulled
similarly in an apparatus using a crucible stand and a heat
-insulating member both made of carbon in accordance with the
conventional method, the apparatus withstood only 5
repetitions of stable pulling of single crystal.

When the single crystal of GaAs was pulled in the
apparatus using the crucible stand and the heat-insulating
member made of carbon, impurities were suffered to mingle
into the melt of raw material for crystal and the single
crystal produced at all was inferior in quality.

The example have been described as invariably
involving the pulling of GaAs single crystal. Of course, this invention can be used equally advantageously in the
pulling of InP or GaP single crystal.

What is claimed is :

(1)  An apparatus for the production of a compound semiconductor single crystal, essentially comprising a high-pressure container, a crucible and a crucible stand disposed inside said high-pressure container, a heat generator encircling said crucible and said crucible stand, a heat-insulating member disposed outside said heat generator, and a crystal pulling device disposed above said crucible in such a manner as to be freely moved in a vertical direction, which apparatus is characterized by said crucible stand and/or said heat-insulating member being formed of sintered pieces of poly-type aluminum nitride containing as a sintering aid at least one member selected from the oxides of the Groups IIIa and IIa elements or sintered pieces of aluminum nitride coated with said poly-type aluminum nitride.

(2) An apparatus according to Claim 1, wherein the oxide of the Group IIa elements is at least one selected from the group consisting of the oxides of calcium, stroutium or barium.

(3)  An apparatus according to Claim 1, wherein said sintering aid contains baron nitride.

(4)  An apparatus according to Claim 1, wherein said poly-type aluminum nitride is made of either of an Al-Si-O-N type compound or an Al-O-N type compound.

(5)  An apparatus according to Claim 2, wherein said Al-Si-O-N type compound is obtained by heating aluminum nitride and silicon dioxide at elevated temperatures enough for reaction.

14 0177194

(6)  An apparatus according to Claim 1, wherein said
oxide of a rare earth element is yttrium oxide.